# EUROPÄISCHE PATENTSCHRIFT

(11) **EP 0 281 807 B1**
(45) Veröffentlichungstag und Bekanntmachung des Hinweises auf die Patenterteilung: **23.06.1993**
(21) Anmeldenummer: 88102308.9
(22) Anmeldetag: 17.02.1988
(51) Int. Cl.: H05K 3/46

(54) **Aufbautechnik für mehrlagige Verdrahtungen**
Additive technique for multilayer wirings
Technique additive pour la fabrication de câblages multicouches

(30) Priorität: 09.03.1987 DE 3707501
(43) Veröffentlichungstag der Anmeldung: 14.09.1988
(73) Patentinhaber: Siemens Nixdorf Informationssysteme Aktiengesellschaft, 33102 Paderborn (DE)
(72) Erfinder: Hadersbeck, Hans, D-8000 München 90 (DE)
(74) Vertreter: Fuchs, Franz-Josef, Dr.-Ing.

(56) Entgegenhaltungen:
- EP-A- 0 062 084
- WO-A-83/02172
- WO-A-85/04780
- DE-C- 1 937 508
- FR-A- 2 197 301
- TOUTE L'ELECTRONIQUE, Nr. 416, Dezember 1976, Seiten 41-44, Paris, FR; P. LEMEUNIER: "Pour les circuits imprimés "hyperfréquences": les polymères fluorés
- PROCEEDINGS OF THE IEEE CUSTOM INTEGRATED CIRCUITS CONFERENCE, Portland, US, 20.-23. Mai 1985, Seiten 55-58; G.F. TAYLOR et al.: "The Wafer Transmission module - Wafer Scale integration packaging"

## Beschreibung

Die Erfindung betrifft ein Verfahren zur Herstellung eines Aufbaus mehrlagiger Verdrahtungen mit einer Trägerplatte aus einem elektrisch leitenden Material oder einem Isolierstoff, in der die isolierten, elektrisch leitenden Durchführungen für den Anschluß der Mehrlagenverdrahtung an die übergeordnete Verdrahtungseinheit enthalten sind, und auf die die einzelnen Schichten schrittweise aufgebracht werden.

Die Entwicklung von Hochleistungs-Rechenanlagen und modernen Nachrichtengeräten hat dazu geführt, daß Leiterzüge auf Leiterplatten immer schmaler und die Abstände der Leiterzüge geringer werden. Für schnelle Rechner sind zur elektrischen Verbindung von hochpoligen bipolaren Schaltkreisen mehrlagige Verdrahtungen erforderlich, die sowohl eine hohe Leitfähigkeit der Leiterbahnen als auch eine große Packungsdichte besitzen.

Für kleinere Packungsdichten und dementsprechend höherer Lagenzahl sind Herstellverfahren bekannt, die die Technik der Mehrlagenkeramik (zum Beispiel Spektrum der Wissenschaft, 9/1983, Seite 94 bis 106) betrieben.

Es ist aber auch bekannt, unter Verwendung von Kunststoff- und Metallfolien mit Feinätztechnik mehrlagige Verdrahtungen in sequentieller Aufbautechnik herzustellen. Wegen der hohen Dielektrizitätskonstante bei der Mehrlagenkeramik und bei der Feinätztechnik vor allem wegen der gröberen Strukturen müssen die einzelnen Bahnen und Schichten weit auseinander angeordnet werden, um ein Nebensprechen zu vermeiden.

Einen Fortschritt stellt die Aufbautechnik dar, die zum Beispiel in der DE-PS 1 937 508 beschrieben und dargestellt ist. Dieses Verfahren zur Herstellung eines mit elektrischen Leitungsbahnen und/oder elektrischen Durchkontaktierungen versehenen Isolierstoffträgers erlaubt nur einen Aufbau von der Bauteileseite her. Es ist in der Lagenzahl begrenzt und gestattet nicht die Herstellung isolierter Leiterbahnstücke in beliebigen Schichten.

Aus der WO-A-85/04780 ist eine Aufbautechnik für mehrlagige Verdrahtungen mit einer Trägerplatte bekannt, wobei die einzelnen Schichten schrittweise aufgebracht werden und zur Aufnahme von Leiterbahnen und Durchkontaktierungen wird ein lichtempfindlicher Kunststoff mit einer Dielektrizitätskonstanze ε ≦ 3,5 verwendet. Dieser Kunststoff verbleibt im Aufbau als lichtempfindlicher Isolierstoff.

Der Erfindung liegt die Aufgabe zugrunde, eine mehrlagige Verdrahtung herzustellen, die sowohl eine hohe Leitfähigkeit der Leiterbahnen als auch eine große Packungsdichte und eine geringe Nebensprechkopplung aufweisen. Dazu muß der gleichmäßig von der Bodenfläche aus beginnende Aufbau der Leiterbahnen und Durchkontaktierungen gewährleistet sein, um eine homogene Füllung der vorgegebenen Durchkontaktierungslöcher und Leiterbahngräben zu erreichen.

Diese Aufgabe wird erfindungsgemäß durch die Merkmale des Anspruchs 1 gelöst. Vorteilhafte Ausführungs formen und Weiterbildungen der Erfindung sind in den Unteransprüchen angegeben.

Unteranspruch 5 betrifft eine Abänderung der Erfindung gemäß Anspruch 1.

Durch den lichtempfindlichen Lack mit der niedrigen Dielektrizitätskonstante ist es nach der Erfindung möglich, eine große Packungsdichte ohne störendes Nebensprechen zu erzie len. Darüber hinaus ist eine hohe Leitfähigkeit der Leiterbahnen gewährleistet. Nach der Erfindung erfolgt ferner ein gleich mäßiges Wachstum des galvanisch aufgebauten Metalls von der Bodenfläche ausgehend, so daß eine homogene Füllung der vorgegebenen Durchkontaktierungslöcher und Leiterbahngräben erreicht wird. Durch die Metallisierung der Oberfläche (von außen) ist es möglich, auch Leiterbahnstücke zu erzeugen, die keine elektrische Verbindung mit den Durchkontaktierungen der Trägerplatte haben. Durch die Metallisierung von außen kann der Aufbau von der sowieso notwendigen Trägerplatte, die im Aufbau verbleibt, mit Durchkontaktierungen beginnen. Die Anzahl der Leiterbahnen ist praktisch nicht begrenzt. Ein weiterer Vorteil der Erfindung liegt darin begründet, daß die stromlose Metallisierung in einem Zug durchgeführt werden kann, so daß der Ablauf einfacher und sicherer wird.

Die Erfindung wird anhand der Figuren erläutert. Es zeigen:
- Figur 1: einen Querschnitt eines Durchkontaktierungsloches bzw. eines Leiterbahngrabens und
- Figur 2: einen perspektivischen Ausschnitt des schichtweisen Aufbaus.

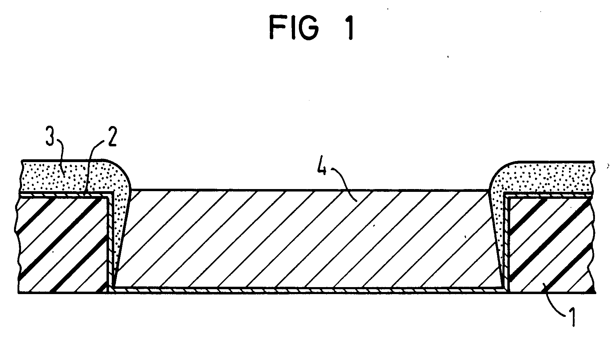

In der Figur 1 ist mit 1 ein lichtempfindlicher Kunstoff bezeichnet, der auf einem in dieser Figur nicht dargestellten Träger aufgetragen ist. Mit 2 ist stromlos abgeschiedenes Metall, zum Beispiel Kupfer, gekennzeichnet, über dem sich eine Galvanikabdeckung 3, zum Beispiel Phenolharz, befindet. Galvanisch aufgebautes Metall 4 füllt ein Durchkontaktierungsloch oder einen Leiterbahngraben.

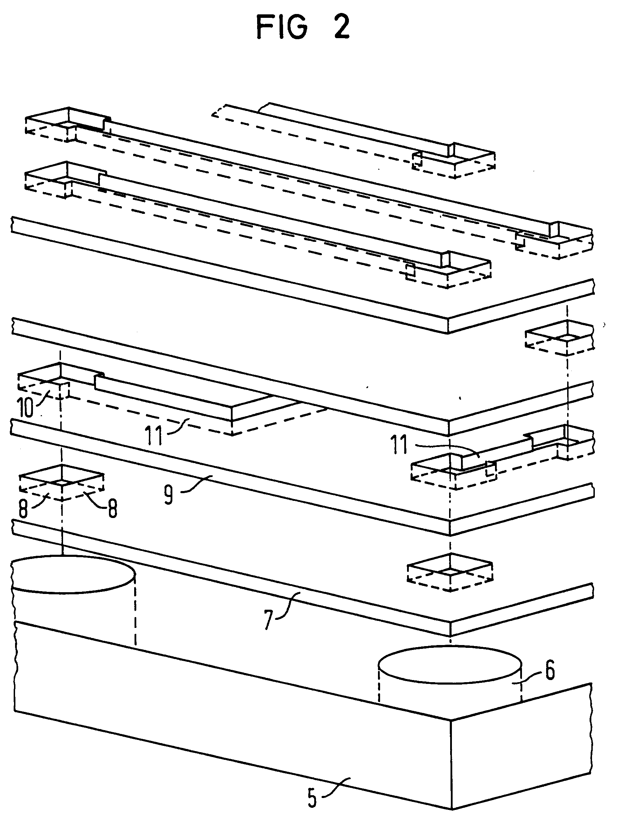

In der Figur 2 sind in einem Träger 5 (Trägerplatte) Durchkontaktierungen 6 dargestellt. Darüber befindet sich die erste Schicht 7 (Druchkontaktierungsebene) einer Mehrlagenverdrahtung aus lichtempfindlichen Kunststoff, der in der Figur 1 mit dem Bezugszeichen 1 gekennzeichnet ist. Diese Schicht enthält Durchkontaktierungen 8. Darüber befindet sich die zweite Schicht 9 (Leiterbahnebene) der Mehrlagenverdrahtung mit Durchkontaktierungslöchen 10 und Leiterbahngräben 11. Über dieser Leiterbahnebene wiederholt sich der Aufbau mit der gewünschten Anzahl von Durchkontaktierungsebenen, Leiterbahnebenen und auch Potentiallagen, so weit diese zur Stromversorgung und zur Erzielung eines definierten Wellenwiderstandes erforderlich sind. Den Abschluß bildet eine Deckfläche, die für den Anschluß von IC's geeignet ist. Auf dieser Deckfläche können die Anschlußpads zum Beispiel mit einer Nickel- und Goldauflage metallisiert werden. Als Deckfläche, eventuell auch schon für die vorletzte Ebene, kann auch ein anderer, lichtempfindlicher Kunststoff, der eine besonders hohe Temperaturfestigkeit besitzt, zum Beispiel eine Lötstopabdeckung, eingesetzt werden. Eine geeignete Lötstopabdeckung ist beispielsweise unter dem Handelsnamen Probimer 52 bekannt.

Die Trägerplatte aus Metall, Keramik oder Kunststoff bildet die stabile Basis für den mehrlagigen Verdrahtungsaufbau. Sie enthält die isolierten, elektrisch leitenden Durchführungen für den Anschluß der Mehrlagenverdrahtung an die übergeordnete Verdrahtungseinheit.

Zunächst wird die Trägerplatte 5 beidseitig mit dem lichtempfindlichen Kunststoff 1 beschichtet, dessen Dielektrizitätskonstante ε < 3 ist (zum Beispiel lichtempfindlichen Epoxidester). Auf der Verdrahtungsseite wird die Kunststoffschicht anschließend mit der Struktur von Durchkontaktierungen bzw.
Leiterbahnen belichtet und entwickelt.

Darauf folgt eine stromlose Metallabscheidung, die das entstandene Relief (Höhe zum Beispiel 10 µm) lückenlos mit einer Metallschicht überzieht.

Im weiteren Verfahrensablauf wird die Galvanikabdeckung entsprechend der Figur 1 erzeugt. Bei passender Viskosität und richtigem Mengenangebot des Lackes werden beim Auftragen des Lackes mittels Roller-Coater o. ä. die Oberflächen und weitgehend auch die Flanken der Vertiefungen bedeckt. Damit gewinnt man die günstigste Voraussetzung für den galvanischen Aufbau. Die Vertiefungen werden bei der galvanischen Abscheidung von der Bodenfläche ausgehend gefüllt.

Abschließend wird die noch an der Oberfläche zugängliche Galvanikabdeckung entschichtet und die ebenfalls nur an der Oberfläche zugängliche, stromlos abgeschiedene Metallschicht durch eine kurze Ätzung entfernt.

Nach einer Einebnung einen Schleifvorgang können weitere Lagen durch Wiederholung des geschilderten Verfahrensablaufes aufgebaut werden.

Zusammenfassend wird der Verfahrensablauf stichpunktartig angegeben:
1. Trägerplatte vorbereiten
2. Beschichtung, beidseitig mittels Tauchziehverfahren. Trockene Schichtdicke zum Beispiel 10 µm.
3. Belichtung
4. Entwicklung
5. Stromlose Metallabscheidung
6. Galvanikabdeckung auftragen
7. Galvanischer Aufbau von Durchkontaktierungen bzw. Leiterbahnen
8. Galvanikabdeckung entschichten
9. Stromlos abgeschiedene Metallschicht ätzen
10. Einebnen
Nächste Schicht 2, 3. usw.

## Patentansprüche

1. Verfahren zur Herstellung eines Aufbaus mehrlagiger Verdrahtungen mit einer Trägerplatte aus einem elektrisch leitenden Material oder einem Isolierstoff, in der die isolierten, elektrisch leitenden Durchführungen für den Anschluß der Mehrlagenverdrahtung an die übergeordnete Verdrahtungseinheit enthalten sind, und auf die die einzelnen Schichten schrittweise aufgebracht werden, wobei zur Aufnahme von späteren Leiterbahnen und Durchkontaktierungen ein lichtempfindlicher Isolierstoff (1), der im Aufbau verbleibt, mit einer Dielektrizitätskonstante ε < 3 verwendet wird und als lichtempfindlicher Isolierstoff ein Kunststoff, zum Beispiel ein mit Zimtsäure verestertes Epoxidharz, verwendet wird, wobei die Trägerplatte auf der Verdrahtungsseite mit dem lichtempfindlichen Isolierstoff beschichtet wird, der mit der Struktur von Durchkontaktierungen (8, 10) bzw. Leiterbahnen (11) belichtet und entwickelt wird, dann auf dieser Fläche eine das ganze entstandene Relief von Durchkontaktierungslöchern bzw. Leiterbahngräben überziehende, stromlose Metallabscheidung (2) erfolgt und anschließend eine selbstjustierende Galvanikabdeckung (3) als Voraussetzung für den folgenden galvanischen Aufbau (4) der Leiterbahnen und Durchkontaktierungen erzeugt wird, worauf nach dem galvanischen Aufbau die noch an der Oberfläche zugängliche Galvanikabdeckung (3) entschichtet, die stromlos abgeschiedene, noch zugängliche Metallschicht (2) weggeätzt und die so erhaltene Oberfläche durch einen Schleifvorgang eingeebnet wird, worauf weitere Lagen durch die Wiederholung des Verfahrensablaufs aufgebaut werden.

2. Verfahren nach Anspruch 1, **dadurch gekennzeichnet,** daß als Galvanikabdeckung (3) ein Lack, zum Beispiel Phenolharzlack dient.

3. Verfahren nach Anspruch 1, **dadurch gekennzeichnet,** daß bei der Galvanikabdeckung (3) der Kanteneffekt ausgenutzt wird, so daß der Lacküberschuß auch die Flanken der Durchkontaktierungslöcher und Leiterbahngräben bedeckt (Figur 1).

4. Verfahren nach Anspruch 1**, dadurch gekennzeichnet,** daß die Trägerplatte beidseitig mit dem lichtempfindlichen Isolierstoff beschichtet ist.

5. Verfahren nach Anspruch 1, **dadurch gekennzeichnet,** daß für die Deckfläche, eventuell auch für die vorletzte Ebene, anstelle des im gesamten Aufbau verwendeten Kunststoffes eine Lötstopabdeckung mit besonders hoher Temperaturfestigkeit eingesetzt wird.

## Claims

1. Method for producing a layout of multilayer wirings with a carrier board composed of an electrically conductive material or an insulating material in which the insulated, electrically conductive bushings for the connection of the multilayer wiring to the higher-level wiring unit are contained, and onto which the individual layers are deposited in steps, a light-sensitive insulating material (1), which remains in the layout and has a dielectric constant of ε < 3, is used for holding subsequent conductor tracks and through-plated holes, and a plastic, for example an epoxy resin which is esterified with cinamic acid, is used as the light-sensitive insulating material, the carrier board being coated on the wiring side with the light-sensitive insulating material which is exposed and developed with the structure of the through-plated holes (8, 10) and conductor tracks (11), non-electrical metal deposition (2), which covers the entire relief of through-plated holes and conductor-track trenches, now taking place on this surface, and a self-adjusting galvanic coating (3) being subsequently produced as a precondition for the following galvanic construction (4) of the conductor tracks and throughplated holes, whereupon the galvanic coating (3) which is still accessible on the surface is removed as a coating after the galvanic construction, the metal layer (2) which is still accessible and is deposited in a nonelectrical manner is etched away, and the surface thus obtained is smoothed by means of a grinding process, whereupon further layers are constructed by repeating the method sequence.

2. Method according to Claim 1, characterised in that a varnish, for example a phenol-resin varnish, is used as the galvanic coating (3).

3. Method according to Claim 1, characterised in that the edge effect is used during the galvanic coating (3), so that the excess varnish also covers the edges of the through-plated holes and conductor track trenches (Figure 1).

4. Method according to Claim 1, characterised in that the carrier board is coated with the light-sensitive insulating material on both sides.

5. Method according to Claim 1, characterised in that a solder-resist covering with a particularly high temperature resistance is used for the covering surface, possibly also for the penultimate plane, instead of the plastic which is used in the entire construction.

## Revendications

1. Procédé pour fabriquer une structure de câblage à couches multiples, comportant une plaque servant de support, en un matériau électriquement conducteur ou en un matériau isolant, dans laquelle sont ménagés les traversées isolées, électriquement conductrices, pour le raccordement du câblage à couches multiples à l'unité de câblage de rang supérieur et sur laquelle les différentes couches sont déposées successivement, et selon lequel, pour recevoir des voies conductrices formées ultérieurement et des contacts traversants formés ultérieurement, on utilise un matériau isolant photosensible (1), qui reste dans la structure et qu'a une constante diélectrique ε < 3, et en tant que matériau isolant photosensible, on utilise une matière plastique, par exemple une résine époxyde estérifiée par l'acide cinnamique, et selon lequel on revêt la face de câblage de la plaque servant de support du matériau isolant photosensible, que l'on expose au moyen de la structure formée de contacts traversants (8, 10) ou de voies conductrices (11) et que l'on développe, puis on effectue sans courant sur cette surface un dépôt métallique (2) qui recouvre l'ensemble du relief obtenu par la présence des trous de contact traversants ou des sillons des voies conductrices, et on applique ensuite un dépôt galvanique s'ajustant de soi-même, qui est un préalable pour former la structure (4) galvanique ultérieure des voies conductrices et des contacts traversants, à la suite de quoi, après la formation de la structure galvanique, on élimine le revêtement galvanique (3) encore accessible à la surface, on supprime par corrosion la couche métallique (2) déposée sans courant et encore accessible, et on réalise un planage de la surface ainsi obtenue en exécutant un meulage, à la suite de quoi, on forme des couches supplémentaires en répétant le cycle opératoire.

2. Procédé suivant la revendication 1, caractérisé par le fait qu'on utilise comme revêtement galvanique (3) un vernis, par exemple un vernis en une résine phénolique.

3. Procédé suivant la revendication 1, caractérisé par le fait que pour le dépôt galvanique (3), on utilise l'effet de bord de sorte que l'excès de vernis recouvre également les flancs des trous de contact traversants et les sillons des voies conductrices. (Figure 1).

4. Procédé suivant la revendication 1, caractérisé par le fait qu'on recouvre les deux faces de la plaque servant de support d'un matériau isolant photosensible.

5. Procédé suivant la revendication 1, caractérisé par le fait que pour la surface supérieure et éventuellement également pour l'avant-dernier plan, à la place de la matière plastique utilisée dans l'ensemble de la structure, on utilise un revêtement empêchant le brasage et ayant une résistance particulièrement grande à la température.
